# EUROPEAN PATENT APPLICATION

(11) **EP 4 628 444 A1**
(43) Date of publication of application: **08.10.2025**
(21) Application number: 24168233.5
(22) Date of filing: 03.04.2024
(51) Int. Cl.: B81C 1/00

(54) **METHOD FOR BONDING WAFERS**

(71) Applicant: Murata Manufacturing Co., Ltd., Nagaokakyo-shi, Kyoto 617-8555 (JP)
(72) Inventor: RINKIÖ, Marcus, 05200 Rajamäki (FI); RYTKÖNEN, Ville-Pekka, 01820 Klaukkala (FI); KILPINEN, Petteri, 02620 Espoo (FI); KUISMA, Elina, 00320 Helsinki (FI); LIUKKU, Matti, 00320 Helsinki (FI); NERA, Kaisa, 00200 Helsinki (FI)
(74) Representative: Boco IP Oy Ab

(57) **Abstract**

This disclosure describes a method for bonding a first wafer to a second wafer and to a third wafer. The method comprises bonding the first surface of the first wafer to the second wafer so that a first temporary anchor region on the first wafer is attached to a second temporary anchor region on the second wafer. At least one first microstructure in the first wafer is then released from the second wafer by etching through the at least one second temporary anchor region on the second wafer.

## Description

### FIELD OF THE DISCLOSURE

The present disclosure relates to wafer bonding, and particularly to temporary attachment between wafers during bonding.

### BACKGROUND OF THE DISCLOSURE

Microelectromechanical (MEMS) devices can be manufactured using silicon technology. Inertial sensors that detect acceleration or angular velocity are one MEMS application. Oscillating micromirrors are another application.

A MEMS device typically comprises a device wafer which has a fixed part and a mobile part. The mobile part is suspended from the fixed part by a flexible suspension arrangement. The MEMS device may also comprise electrical transducers which are configured to measure the movement of the mobile part in relation to the fixed part and/or to keep the mobile part in motion.

In some applications, the mobile part of a MEMS device is intended to move only in the plane of the device wafer. The electrical transducers may in such cases often be formed in the device wafer itself, for example by forming capacitors between the mobile part and the fixed part. However, there are many applications where the mobile part needs to rotate (or move in linear translation) out of the plane of the device wafer. Electrical transducers which measure or drive such motion typically include fixed electrodes which are not a part of the device wafer. Such electrodes usually lie adjacent to the device wafer in the out-of-plane direction.

The device wafer is typically thin. It can be attached to a handle wafer which provides structural support. A protective structure, such as a capping wafer, is typically attached to the other side of the device wafer. Fixed electrodes for out-of-plane electrical transducers may be located on the handle wafer or on the capping wafer. However, a general challenge in this arrangement is that the fixed electrodes and/or the mobile part may be shifted away from their intended position if the wafers experience thermal or mechanical stress. The electrical transducers may then not function properly.

Document US20230160921 discloses a MEMS device where the impact of thermal stress has been reduced by forming fixed electrodes in two device layers. However, the two device layers in US20230160921 are epitaxially deposited onto a substrate, which is a very slow process.

### BRIEF DESCRIPTION OF THE DISCLOSURE

An object of the present disclosure is to provide a method which alleviates the above problem.

The object of the disclosure is achieved by a method which is characterized by what is stated in the independent claims. Some embodiments of the disclosure are disclosed in the dependent claims.

The disclosure is based on the idea of bonding a second device wafer to a first device wafer and utilizing a temporary anchor between them. The advantages of this arrangement are that fixed and mobile parts can be efficiently and reliably formed and aligned in two layers.

### BRIEF DESCRIPTION OF THE DRAWINGS

In the following the disclosure will be described in greater detail by means of preferred embodiments with reference to the accompanying drawings, in which:
Figure 1 illustrates a method for a first wafer to a second wafer and a third wafer.
Figures 2a - 2h illustrate a method where microstructures are kept in place by a temporary anchor structure.
Figures 3a - 3c illustrate a method where a permanent anchor structure is utilized.
Figures 4a - 4b illustrate the placement of temporary anchor regions.
Figures 5a - 5e illustrates an alternative method.

### DETAILED DESCRIPTION OF THE DISCLOSURE

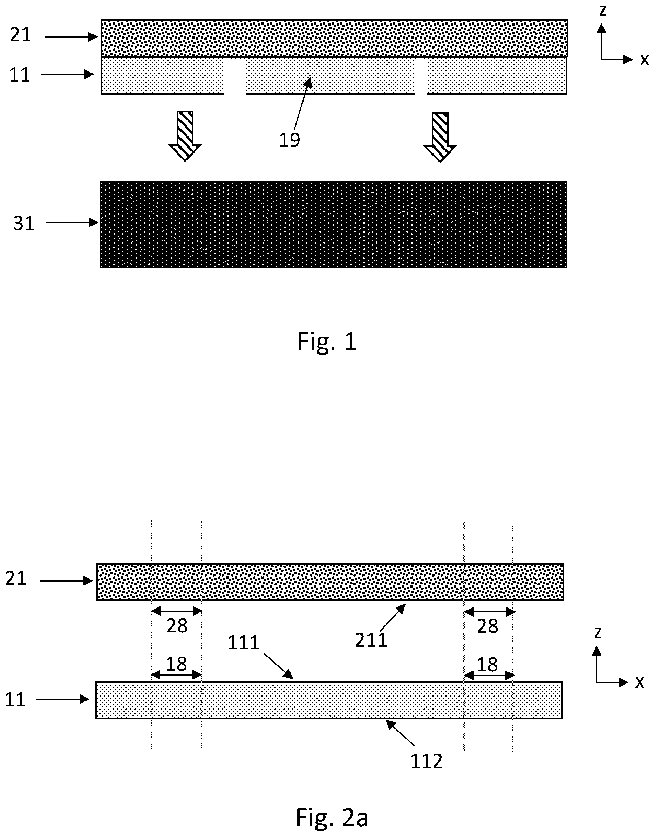

Figure 1 illustrates a method for bonding a first wafer 11 to a second wafer 21 and to a third wafer 31. The first wafer 11 has first been bonded to the second wafer 21 (this step has not been separately illustrated), and the two of them are then together bonded to the third wafer 31 in figure 1.

The first wafer 11 contains patterned microstructures 19. These microstructures 19 may comprise fixed structures and/or mobile structures. The microstructures can for example include fixed transducer electrodes, mobile transducer electrodes and/or mobile proof masses. The microstructures 19 have to be patterned before the wafer stack 11+21 is bonded to the third wafer 31, because the first wafer 11 will not be accessible for independent patterning after it is sealed between wafers 21 and 31. A general challenge in this method is that the wafer stack 11+21 must be moved onto the third wafer 31 with exposed microstructures 19, without being attached to a firm support. These microstructures 19 may be easily damaged when this transfer is performed.

Another alternative, which has not been illustrated, is that the first wafer 11 may first be bonded to the third wafer 31 and patterned with microstructures. The second wafer 21 may then be bonded to the other side of the first wafer 11. However, it is difficult to bond a wafer to any kind of mobile microstructure. This method is therefore viable only for a limited number of microstructure designs.

This disclosure describes a method for bonding a first wafer to a second wafer and to a third wafer. The first wafer and the second wafer are silicon wafers. The first wafer comprises at least one first temporary anchor region. The first wafer has a first surface and a second surface. The second wafer comprises at least one second temporary anchor region.

The method comprises the step of bonding the first surface of the first wafer to the second wafer so that the at least one first temporary anchor region on the first wafer is attached to the at least one second temporary anchor region on the second wafer.

The method also comprises the step of patterning at least one first microstructure in the first wafer, so that the at least one first temporary anchor region lies on the at least one first microstructure.

The method also comprises the step of bonding the second surface of the first wafer to the third wafer. The method also comprises the step of releasing the at least one first microstructure in the first wafer from the second wafer by etching through the at least one second temporary anchor region on the second wafer.

The first wafer may be called a first device wafer or a first structure wafer. The second wafer may be called a second device wafer or a second structure wafer. The third wafer may be called a handle wafer or a support wafer. The first and second wafers 11 and 21 may be MEMS device wafers. The third wafer 31 may provide structural support for the first and second wafers 11 and 21 after they have been bonded to the third wafer.

The thickness of the first wafer 11 in the z-direction may be substantially equal to the thickness of the second wafer 21 in the z-direction. Alternatively, these thicknesses may be different. The thickness of the first and second wafers in the z-direction may for example be in the range 10 - 200 µm, or in the range 20 - 100 µm. The thickness of the third wafer 31 in the z-direction may for example be at least 2 times, at least 5 times or at least 10 times greater than the thicknesses of the first and second wafers 11 and 21. The thickness of the third wafer in the z-direction may for example be in the range 300 µm - 700 µm. The wafer thicknesses mentioned in this paragraph may be the wafer thicknesses in the finished device.

The device formed by the first, second and third wafers may for example be a MEMS device. It may also be called a double-layer MEMS device. The device may for example be an accelerometer, or it may be a gyroscope. Alternatively, the device may be a MEMS mirror or a MEMS microphone.

Figures 2a - 2f illustrate the method. Figure 2a shows a first wafer 11 and a second wafer 21. The first wafer 11 has a first surface 111 and a second surface 112. These surfaces are opposite to each other. The first surface 111 defines an xy-plane and z-direction which is perpendicular to the xy-plane. This xyz coordinate-system is illustrated in the figures of this disclosure. The xz-cross-sections and xy-cross-sections illustrated in the figures of this disclosure may illustrate only a part of the device. In other words, the wafers may extend in the xy-plane beyond the illustrated areas.

The first wafer comprises at least one first temporary anchor region. Two first temporary anchor regions 18 are illustrated in figure 2a, but the number of first temporary anchor regions 18 could alternatively be one, or any number greater than two.

The second wafer comprises at least one second temporary anchor region, here illustrated as regions 28. The number of second temporary anchor regions 28 could alternatively be one, or any number greater than two. The second wafer comprises a bonding surface 211 which is intended to be bonded to the first surface 111 of the first wafer 11.

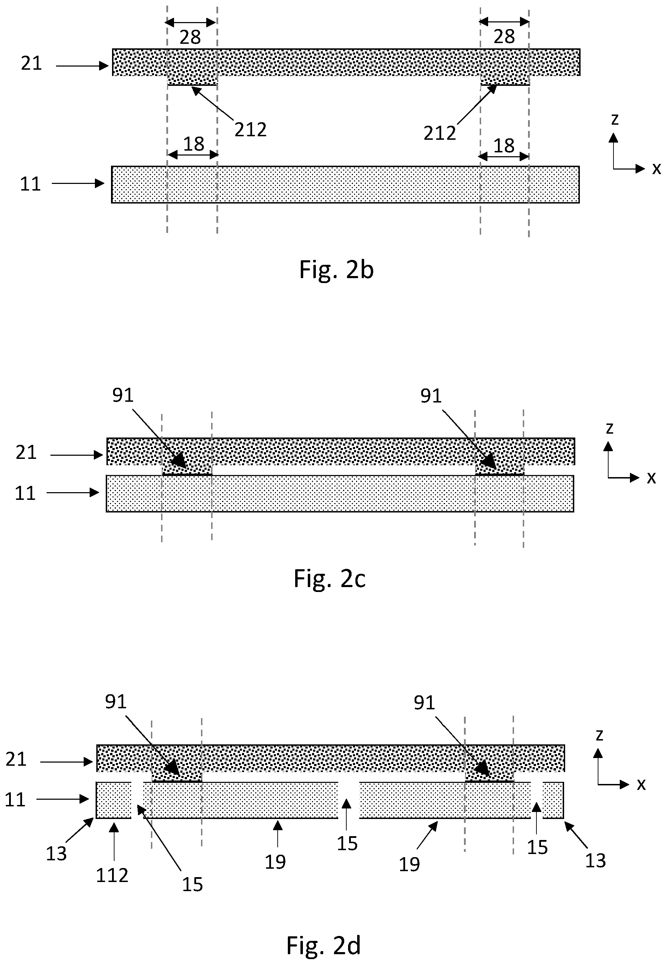

Figure 2b illustrates an optional step where protrusions 212 are formed on the bonding surface 211 of the second wafer 21 in the second temporary anchor regions 28. These protrusions 212 may be formed by recessing the other parts of the bonding surface 211 for example by etching or by local oxidation of silicon (LOCOS).

Similar protrusions could alternatively be formed on the first wafer 11 in the at least one first temporary anchor region 18, without forming protrusions on the second wafer 21, or vice versa. Alternatively, protrusions may be formed in the temporary anchor regions of both the first and second wafers 11 and 21. Neither of these options has been illustrated, but either one of them may be used in any embodiment presented in this disclosure.

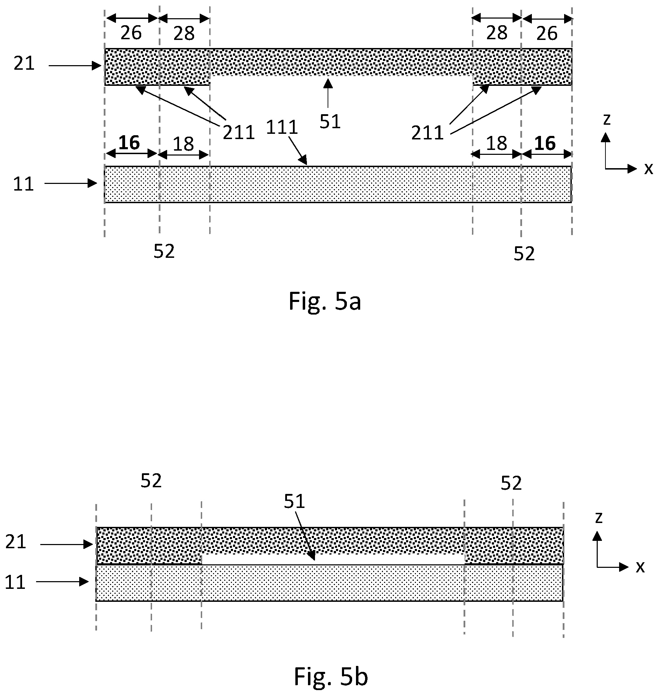

The first surface 111 of the first wafer and/or the bonding surface 211 of the second wafer may alternatively comprise a cavity, in which case protrusions may not be needed. The first surface 111 of the first wafer 11 and/or the bonding surface 211 of the second wafer 21 will then be bonded to each in all regions except at the cavity. This possibility will be discussed with reference to figures 5a - 5e below.

It can be seen in figure 2b that the first wafer 11 has been placed adjacent to the second wafer 21 so that the first bonding surface 111 faces the second bonding surface 211, and so that the first temporary anchor regions 18 on the first wafer are aligned (in the z-direction) with the second temporary anchor regions 28 on the second wafer.

In figure 2c, the first wafer 11 is bonded to the second wafer 21. This may for example be performed in a Si - Si bonding process, or a fusion-bonding process between a Si surface (on one of the wafers) and a SiOz surface (on the other wafer). The at least one first temporary anchor region 18 on the first wafer 11 is thereby attached to the at least one second temporary anchor region 28 on the second wafer 21. A temporary anchor structure 91 is formed at each location where region 18 is bonded to region 28.

Figure 2d illustrates a step where the first wafer 11 has been patterned so that it comprises first microstructures 19. This patterning may be performed by etching patterned first openings 15 in the first wafer 11. After this patterning step, the first wafer 11 also comprises other fixed structures 13 which will remain immobile in relation to the second wafer 21. The first anchor regions 18, marked with dotted lines in figure 2d, lie within one of the first microstructures 19 in figure 2d. Each first microstructure 19 is therefore attached to the second wafer with a temporary anchor structure 91. The temporary anchor structure 91 will therefore keep the first microstructure 19 fixed until the temporary anchor structure is removed.

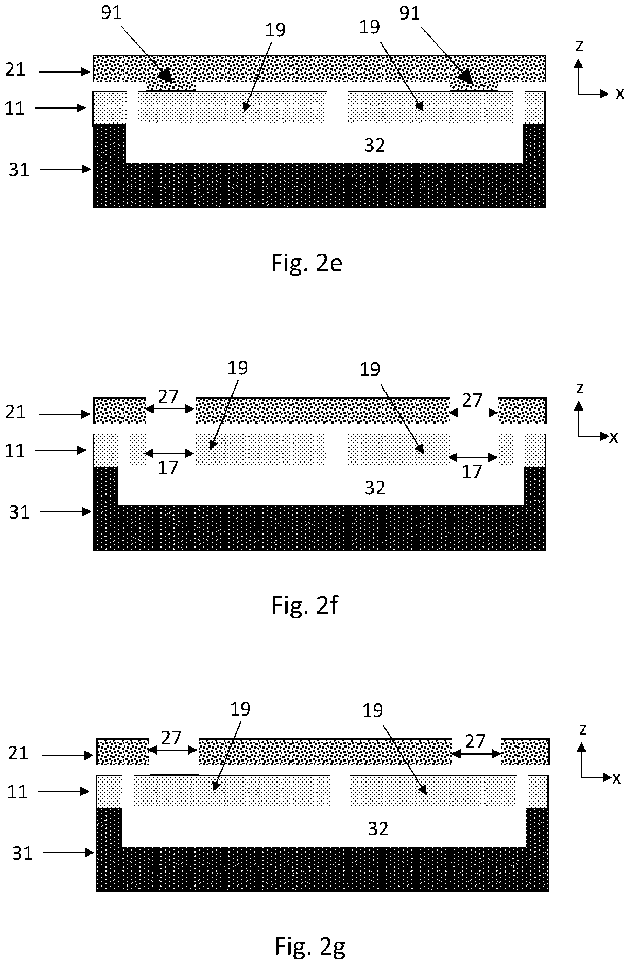

The thickness in the z-direction of the first wafer 11 in figures 2a - 2c may be greater than the intended thickness of this layer in the finished device. If that is the case, the thickness may be adjusted to its final value before or during the etching sequence where the first wafer 11 is patterned in figure 2d. In other words, in any embodiment presented in this disclosure, the thickness of the first wafer may be reduced before the second surface of the first wafer is bonded to the third wafer. This optional thickness reduction has not been illustrated. Further adjustments to the thickness of the first wafer 11 will typically not be possible from figure 2e onward.

Two first microstructures 19 are illustrated in figures 2d. The number of first microstructures could alternatively be one, or it could be greater than two. If there are multiple first microstructures 19, then they don't have to lie next to each other as in figure 2d. In other words, a fixed structure in the first wafer could extend between the first microstructures 19 in the xy-plane. Furthermore, there may be multiple first anchor regions 18 may lie within the same microstructure 19. These options have not been separately illustrated.

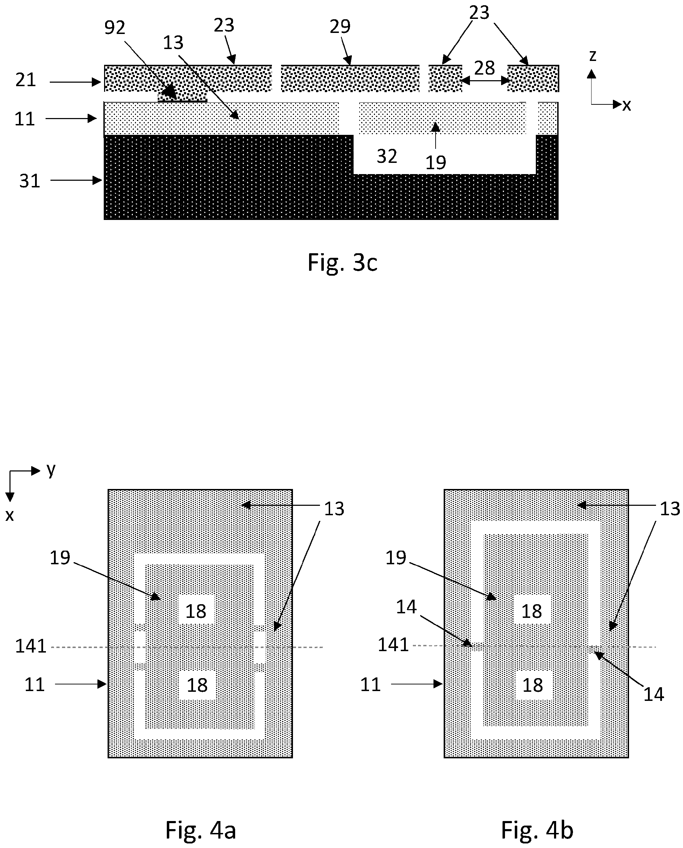

Each of the at least one first microstructures 19 may be suspended with suspenders 14 (schematically illustrated in figure 4 below) from the fixed structure 13 or from other fixed anchor points. These suspenders could be of any shape.

The first microstructure 19 may for example be a proof mass. If the device formed by the first and second device wafers 11 and 21 is an accelerometer, then the proof mass may be configured to move in relation to the fixed structure 13 when the device undergoes acceleration. If the device formed by the first and second device wafers 11 and 21 is a gyroscope, then the proof mass may be driven into primary oscillation by one or more drive transducers, and it may be configured to undergo secondary oscillation when the device undergoes angular rotation. The suspenders 14 may in this case be configured to allow the proof mass to move in relation to the fixed structure 13 (or any other corresponding anchor point).

The first microstructure 19 could alternatively function for example as an electrode in an electrical transducer which is configured to measure the movement of a proof mass which is located in the second wafer. Or it could be an electrode used for other purposes, or a platform used for routing electrical signals.

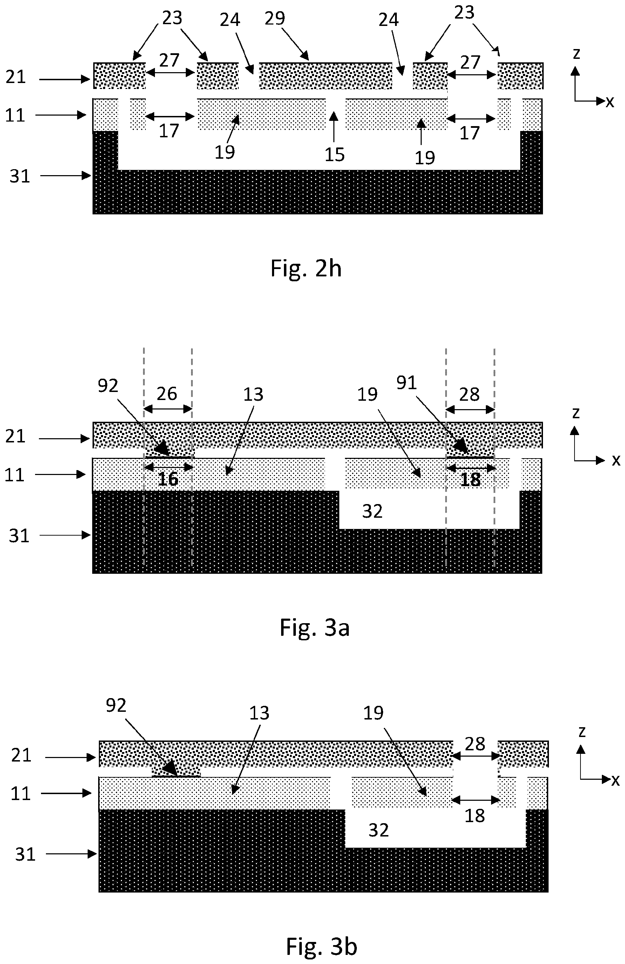

Each first microstructure 19 may for example be suspended from the same fixed structures 13 (or anchor points) as one of the second microstructures 29, which will be discussed with reference to figure 2h below. Or the fixed structures 13 and/or microstructures 19 in the first wafer 11 may be rigidly fixed to corresponding fixed structures 23 (from which second microstructures 29 are suspended) in the second wafer 21. In either case, if the wafers experience thermal or mechanical stress which deforms the fixed structures 13/23 (or anchor points), the mutual alignment of the microstructures 19/29 may still be substantially the same as it was before the deformation occurred. The suspenders 14 may in this case be configured to allow the first and second microstructures 19 and 29 to maintain their mutual alignment despite possible deformation in the fixed structures 13 or the anchor points.

In figure 2e the second surface 112 of the first wafer 11 is bonded to the third wafer 31. The third wafer 31 may for example comprise a cavity 32. The first wafer 11 may be aligned with the third wafer 31 so that the at least one first microstructure 19 is aligned with the cavity 32. In other words, the microstructures 19 may be placed above the cavity. This gives them some freedom of movement, since they are not bonded to the third wafer 31. The third wafer 31 does not necessarily have to comprise a cavity 32. The at least one microstructure 19 may also be prevented by other means from being fixed to the third wafer 31 in the bonding process.

The at least one microstructure 19 remains attached to the second wafer 21 via temporary anchor structure 91 as the stack 11+12 is moved onto the third wafer 31 in figure 2e. The microstructures 19 are then, in figure 2f, released from the second wafer 21. This release may be achieved by performing a DRIE etch or any other suitable etch.

It may in some applications be beneficial to select the thickness of the second wafer 21 in the z-direction in figures 2a - 2e so that it is greater than the intended thickness of this layer in the finished device. The thick second wafer 21 will then give better support to the first wafer 11 until they are bonded to the third wafer. If the initial thickness of the second wafer 21 is greater than the intended final thickness, then the thickness of the second wafer 21 may be adjusted to its final value before or during the etching sequence where the temporary anchor is released in figure 2f or 2g. More generally, in any embodiment presented in this disclosure, the thickness of the second wafer 21 may be reduced after the second surface of the first wafer 11 has been bonded to the third wafer 31. This optional thickness reduction has not been illustrated.

However, the initial thicknesses of the first and second wafers may in other applications be substantially equal to their intended final thickness. No separate adjustment steps are needed in that case.

Figure 2f illustrates an etching process which proceeds through both the first wafer 11 and the second wafer 21. This etching process leaves openings 17 and 27 where the first and second temporary anchor regions 18 and 28 and the temporary anchor structure 91 used to be. In other words, releasing the at least one first microstructure 19 in the first wafer 11 from the second wafer 21 may comprise etching through the at least one first temporary anchor region 18 on the first wafer 11. In figures 2f, 2g and 2h, the second wafer 21 may remain fixed to the first wafer 11 in regions which lie beyond the illustrated xz-cross-section.

Figure 2g illustrates an alternative to Figure 2f. In other words, the step shown in figure 2g is performed after the step shown in figure 2e, not after the one shown in 2f. In figure 2g the release etch process proceeds through the second wafer 21, but not through the first wafer 11. The temporary anchor structures 91 are removed, just as in figure 2f, but the opening 27 is formed only in the second wafer 21.

The method may also comprise forming at least one second microstructure in the second wafer in the same etching process where the at least one first microstructure in the first wafer is released from the second wafer. This is illustrated in figure 2h, where the second wafer 21 comprises a second microstructure 29. The second microstructures 29 may be suspended from fixed parts 23 of the second wafer 21 with flexible suspenders. Each second microstructure 29 may, but do not have to, be aligned with an underlying first microstructure 19 in the first wafer 11. The first and second microstructures could be used in a variety of applications, and the design of the microstructures in both the first wafer 11 and the second wafer 21 will depend on the application.

Second openings 24 in the second wafer 21 determine the pattern of the second microstructure 29 in the second wafer 21 may be etched in the same etching process where openings 17 and/or 27 are etched to remove the temporary anchor structures 91. The second openings 24 do not have to be aligned with the first openings 15 in the first wafer 11. After the (optional) patterning of the second wafer 21 in figure 2h, the device can be sealed, for example with a cap wafer (not illustrated) which is placed on top of the second wafer 21. The second microstructures 29 can therefore be protected soon after it has been formed.

Figures 3a - 3c illustrate a method where the first wafer 11 also comprises at least one first permanent anchor region 16, and the second wafer 21 also comprises at least one second permanent anchor region 26. The method illustrated in these figures comprises attaching the at least one first permanent anchor region 16 on the first wafer 11 to the at least one second permanent anchor region 26 on the second wafer 21 when the first surface 111 of the first wafer 11 is bonded to the second wafer 21.

A permanent anchor structure 92 is thereby formed between the first and second wafers 11 and 21 when they are bonded to each other. This permanent anchor structure 92 is protected (not removed) in the etching process shown in figure 3b, where the temporary anchor structure 91 is removed. Similarly, if the second wafer 21 is patterned in the same process where the temporary anchor structure 91 is removed, as figure 3c illustrates, the permanent anchor structure 92 still remains in the device after the etching process. The permanent anchor structure 92 may join a fixed part 13 in the first wafer 11 to a fixed part 23 in the second wafer 21.

In any embodiment presented in this disclosure, the at least one first temporary anchor region 18 on the first wafer 11 may comprise two or more first temporary anchor regions 18. The two or more first temporary anchor regions 18 may lie on the same first microstructure 19 in the first wafer 11. Said first microstructure 19 may have an axis 141 in the plane of the first wafer. The two or more first temporary anchor regions 18 may be placed symmetrically in relation to the axis 141.

This is illustrated in figures 4a - 4b. Figure 4a shows the first wafer 11 in the xy-plane. The axis 141 may in figure 4a be defined by the geometry of the first microstructure 19. The axis 141 divides the first microstructure into symmetric upper and lower sides (mirror symmetry with respect to the axis 141). In other words, the axis 141 may be a symmetry axis. The suspenders which extend from the microstructure 19 to the fixed part 13 do not have to lie on the axis 141, although they may lie on said axis.

Figure 4b illustrates an embodiment where the axis 141 is defined by the location of flexible suspenders 14 which extend in the y-direction from the fixed part 13 to the first microstructure 19. The geometry of the first microstructure 19 is in this case asymmetric in relation to the axis 141. The first microstructure may be configured to rotate about the axis 141, for example in response to acceleration in the z-direction. The suspenders 14 may in this case be torsion springs. The axis 141 may in this case be a rotation axis.

In both figure 4a and 4b, the two or more first temporary anchor regions 18 may be placed symmetrically in relation to the axis 141.

Figure 5a illustrates an alternative method where the bonding surface 211 of the second wafer 21 comprise a cavity 51. The first surface 111 of the first wafer 11 and/or the bonding surface 211 of the second wafer 21 will then be bonded to each in all regions except at the cavity.

Both wafers 11 and 21 comprise temporary anchor regions 18, as in previous examples. Both wafers 11 and 21 may also comprise permanent anchor regions 16 and 26, respectively. The permanent anchor regions 16 and 26 may be adjacent to the temporary anchor regions 18 and 28, as figure 5a illustrates. The permanent anchor regions 26 may comprise all of the bonding surface 211 which is not a temporary anchor region 28. The temporary anchor regions 18 and 28 maybe adjacent to the cavity 51, as figure 5a illustrates.

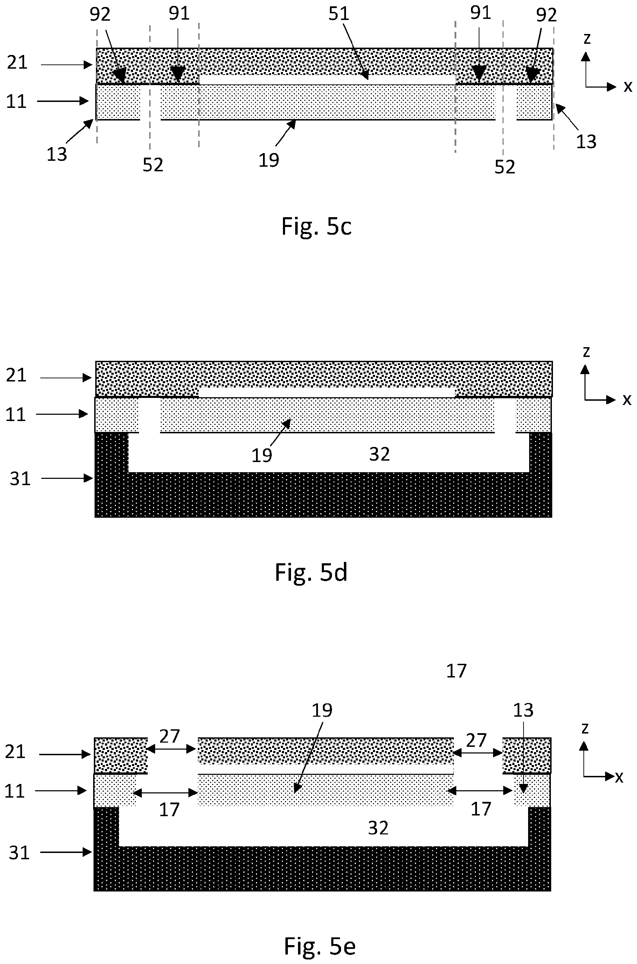

Figure 5b illustrates the bonding of the first and second wafers 11 and 21, figure 5c illustrates the patterning of a first microstructure 19, which may be aligned with the cavity 51 in the z-direction. The edges of the first microstructure 19 may coincide with the borders 52 between the temporary anchor regions 18, 28 and the permanent anchor regions 16, 26. Figure 5d illustrates the bonding of the stack 11+12 onto the third wafer 31, and figure 5e illustrates the release of the first microstructure 19 by the removal of the temporary anchor regions 18 and 28 from the first and second wafers, so that only openings 17 and 27 remain. All options discussed above with reference to figures 2c - 2h, 3a - 3c and 4 apply to figures 5b - 5e as well.

## Claims

1. A method for bonding a first wafer to a second wafer and to a third wafer, wherein:
- the first wafer and the second wafer are silicon wafers,
- the first wafer comprises at least one first temporary anchor region
- the first wafer has a first surface and a second surface,
- the second wafer comprises at least one second temporary anchor region, and
the method comprises:
- bonding the first surface of the first wafer to the second wafer so that the at least one first temporary anchor region on the first wafer is attached to the at least one second temporary anchor region on the second wafer,
- patterning at least one first microstructure in the first wafer, so that the at least one first temporary anchor region lies on the at least one first microstructure,
- bonding the second surface of the first wafer to the third wafer,
- releasing the at least one first microstructure in the first wafer from the second wafer by etching through the at least one second temporary anchor region on the second wafer.

2. A method according to claim 1, wherein the first wafer also comprises at least one first permanent anchor region, the second wafer also comprises at least one second permanent anchor region, and the method also comprises:
- attaching the at least one first permanent anchor region on the first wafer to the at least one second permanent anchor region on the second wafer when the first surface of the first wafer is bonded to the second wafer.

3. A method according to any of claims 1-2, wherein the method also comprises:
- forming at least one second microstructure in the second wafer in the same etching process where the at least one first microstructure in the first wafer is released from the second wafer.

4. A method according to any of claims 1-3, wherein releasing the at least one first microstructure in the first wafer from the second wafer also comprises etching through the at least one first temporary anchor region on the first wafer.

5. A method according to any of claims 1-4, wherein the at least one first temporary anchor region on the first wafer comprises two or more first temporary anchor regions, and the two or more first temporary anchor regions lie on the same first microstructure in the first wafer, and said first microstructure has an axis in the plane of the first wafer, and the two or more first temporary anchor regions are placed symmetrically in relation to the axis.

6. A method according to any of claims 1-5, wherein the thickness of the first wafer is reduced before the second surface of the first wafer has been bonded to the third wafer.

7. A method according to any of claims 1-6, wherein the thickness of the second wafer is reduced after the second surface of the first wafer has been bonded to the third wafer.
